# EUROPÄISCHE PATENTSCHRIFT

(11) **EP 1 338 538 B1**
(45) Veröffentlichungstag und Bekanntmachung des Hinweises auf die Patenterteilung: **11.08.2004**
(21) Anmeldenummer: 02003614.1
(22) Anmeldetag: 16.02.2002
(51) Int. Cl.: B65H 3/08

(54) **Vorrichtung und Verfahren zur Beladung / Entladung eines Trommelbelichters**
Method and device for loading / unloading a drum plotter
Procédé et dispositif de chargement / déchargement d' un traceur a tambour

(43) Veröffentlichungstag der Anmeldung: 27.08.2003
(73) Patentinhaber: Lüscher, Ursula, 5616 Meisterschwanden/AG (CH); Lüscher, Hans, 5600 Lenzburg (CH)
(72) Erfinder: Graf, Michael, 5600 Lenzburg (CH); Berner, Peter, 5102 Rupperswil (CH)
(74) Vertreter: EGLI-EUROPEAN PATENT ATTORNEYS

(56) Entgegenhaltungen:
- WO-A-01/08404
- US-A- 5 558 320
- US-A- 6 042 101
- US-A- 6 084 602

## Beschreibung

Die Erfindung betrifft eine Vorrichtung zur Beladung und/oder Entladung eines Belichters, insbesondere eines Trommelbelichters, mit Druckplatten, gemäß dem Oberbegriff des Anspruchs 1. Eine derartige Vorrichtung ist durch das Dokument US-A-5 558 320 bekannt. Die Erfindung betrifft ausserdem ein auf dieser Vorrichtung beruhendes Drucksystem gemäß Anspruch 1 und Verfahren gemäß Anspruch 28.

Bücher, Zeitungen, Prospekte oder andere zu bedruckende Produkte werden mittels unterschiedlicher Druckverfahren hergestellt. Die Herstellung solcher Druckerzeugnisse kann einerseits über konventionelle Druckverfahren, wie Flach-, Hoch-, Tief- oder Siebdruck und andererseits über digitale Verfahren, wie zum Beispiel Computer-to-Plate (CTP) Technik, erfolgen. Beim Offsetdruck werden die Druckerzeugnisse unter Verwendung von Druckformen hergestellt. Dabei wird auf Druckformrohlinge - auch Druckplatten genannt - das zu druckende Bild oder der Text übertragen. Hierbei wird eine auf einer Metall- oder Kunststoffplatte aufgetragene, lichtempfindliche Schicht, silberbasierend oder aus einem Photopolymer, mittels UV-Strahlung belichtet. Gerade im Bereich der CTP-Technik werden daneben auch Thermoplatten verwendet, die durch Einwirkung bestimmter Temperaturen bebildert werden können. Laser eignen sich dabei sowohl zur Belichtung photosensitiver Platten, als auch zur thermischen Bebilderung. Die Grösse der herzustellenden Druckplatte ist abhängig von dem zu druckenden Objekt. Für alle Verfahren der Drucktechnik gehören verschiedenste Plattenformate zum Stand der Technik. Im Bereich der CTP-Technik sind eine Reihe Systeme zur Bebilderung von Druckplatten unterschiedlichster Formate seit langem bekannt, wie zum Beispiel der Laserstepper von Misomex, der Laserstar von Krause oder Xpose! der Firma Lüscher.

In der Druckereitechnik ist Zeit eine Schlüsselkomponente. Die Automatisierung der Druckplattenherstellung ist deshalb eine logische Konsequenz. Denn die vollautomatische Druckplattenherstellung als ein Arbeitsschritt des gesamten Druckprozesses beschleunigt den Durchsatz und steigert die Produktivität einer Druckerei.

DE-A 40 38 544 beschreibt eine Vorrichtung zur Herstellung von Druckplatten. Die Plattenrohlinge sind dabei in Stapeln auf Stapelträgern innerhalb eines Magazins angeordnet. Dieses Magazin enthält einen als Paternoster ausgebildeten, angetriebenen Umlaufförderer mit mehreren hintereinander angeordneten Stapelträgern. Die Stapelträger können mittels Verschiebeeinrichtung in horizontaler Richtung aus dem Magazin entnommen werden und durch eine Aufnahme- oder Zubringvorrichtung auf den Kopiertisch befördert werden. Diese Zubringvorrichtung umfasst einen Saugrahmen mit Saugern. Der Saugrahmen ist in horizontaler und vertikaler Ebene bewegbar und kann einen Plattenrohling auf einen Kopiertisch transferieren. Nachteilig an dieser Vorrichtung ist insbesondere der komplizierte Aufzugmechanismus innerhalb des Magazins.

Die in DE-C1 41 05 269 beschriebene Vorrichtung zur Druckplattenbeladung und -entladung ist weniger kompliziert als die vorher beschriebene Vorrichtung. Hier sind die Plattenrohlinge, ebenfalls in Kassetten gelagert, turmartig als Magazin gestapelt. Die einzelnen Plattenrohlinge können aus einer gewünschten Kassette mittels einer Zubringvorrichtung zum Kopiertisch transferiert werden. Dazu können die Kassetten in horizontaler Ebene aus dem Magazin verfahren werden, so dass die Zubringvorrichtung Zugriff auf die einzelnen Plattenrohlinge nehmen kann. Nicht jede Kassette ist einzeln aus dem Turm ausfahrbar, sondern es wird jeweils immer der Teil des Turms ausgefahren, so dass die gewünschte Kassette mit den Druckplatten zuoberst angeordnet ist. Die Zubringvorrichtung ihrerseits umfasst einen Drehstern, an dessen auskragenden Schwenkarmen Saugköpfe befestigt sind.

Nachteilig an den in DE-A 40 38 544 und DE-C 41 05 269 beschriebenen Vorrichtungen ist, dass sie nicht in der Lage sind, zylindrische Trommelbelichter zu beschicken.

In EP-A 0822 453 ist eine Vorrichtung und ein Verfahren zur Aufnahme und zum Transport von Druckplatten in eine automatisierte Belichtungseinrichtung beschrieben. Eine Vielzahl von Druckplatten ist dabei in Form von Stapeln in Kassetten bzw. Magazinen gelagert. Dabei können verschiedene Magazine verschiedene Plattenformate beinhalten. Die in der Anmeldung beschriebene Plattenentnahme erfolgt über eine zubringvorrichtung. Dazu werden die gewünschten Plattenformate mittels eines komplexen Aufzugmechanismus für die Zubringvorrichtung erreichbar angeordnet. Die Zubringvorrichtung umfasst eine horizontal angeordnete und horizontal verschiebbare Platte mit Saugköpfen, mittels derer die zu bebildernde Platte über Vakuum aufgenommen werden kann. Nachteilig an dieser Vorrichtung ist insbesondere der komplizierte Aufzugmechanismus. Ausserdem bietet diese Anmeldung keine Lösung an, wie die planare Druckplatte schlussendlich von der Zubringvorrichtung, an der sie, wie beschrieben, mittels Vakuum angeordnet ist, in den zylindrischen Trommelbelichter eingegeben werden kann.

Eine Vorrichtung zur Beladung von Trommelbelichtern ist aus EP-A 0887 181 bekannt. Dabei wird eine Druckplatte, die mittels Vakuum planar an einer Zubringvorrichtung angeordnet ist, mit Hilfe einer Beschickungseinrichtung in einen zylindrischen Trommelbelichter eingelegt. Über rotierende Walzen wird die Druckplatte von der Zubringvorrichtung an die Beschickungseinrichtung übergeben. Die Beschickungseinrichtung ihrerseits wandert unter Mitnahme der Druckplatte über Schienen entlang der Innenfläche des Trommelbelichters. Dieselbe Beschickungseinrichtung kann in umgekehrter Richtung wandern und dadurch eine bereits bebilderte Druckplatte aus dem Trommelbelichter zu einer nachgeschalteten Entwicklungsmaschine transferieren. Nachteilig an dieser Einrichtung ist ihre Komplexität. Zum einen muss ein Walzensystem zur Abnahme der Druckplatte von der Zubringvorrichtung vorhanden sein und zum anderen müssen spezielle Schienensysteme an einem Trommelbelichter angeordnet sein, so dass die Beschickungseinrichtung entlang der Innentrommel wandern kann. Ausserdem eignet sich diese Vorrichtung lediglich zur Beschickung von Innentrommelbelichtern.

Zum Stand der Technik gehören ebenfalls auf dem Markt erhältliche Vorrichtungen zur Druckplattenbeladung und - entladung wie beispielsweise das Plattenbeladesystem (PHS) zum CTP-Belichter "Xpose!" der Firma Lüscher. Bei dieser Vorrichtung sind die Druckplatten planar und stapelweise in Kassetten gelagert. Diese Kassetten sind aufeinander angeordnet und in horizontaler Richtung aus der Frontseite ausfahrbar. Die Zubringvorrichtung umfasst einen Zylinder und eine Einrichtung zur Positionierung des Zylinders. Der Zylinder ist an der Positionierungseinrichtung in Bezug auf seine Längsachse drehbar gelagert. Am Zylinder sind Saugköpfe angeordnet, die mit einem Vakuumsystem verbunden sind. Durch die Positionierungseinrichtung ist der Zylinder sowohl in vertikaler als auch in horizontaler Richtung verfahrbar. Zur Druckplattenaufnahme wird eine Kassette horizontal aus dem Kassettenstapel aufgeschoben und der zylinder vertikal auf die Drucklatte abgesenkt, bis die Saugköpfe Kontakt mit der Druckplatte nehmen. Der Zylinder wird mittels horizontaler Bewegung der Positionierungseinrichtung bei angeschaltetem Vakuum über die Druckplatte gedreht, wodurch die oberste Druckplatte einer Kassette beim Drehen des Zylinders aussen an dem Zylinder festgehalten wird. Mittels des vertikalen Antriebs der Positionierungseinrichtung wird der Zylinder zusammen mit der Druckplatte nach oben gezogen. Anschliessend wird der Zylinder mit der aufgenommenen Druckplatte mittels horizontaler Verschiebung durch die Positionierungseinrichtung über die Trommel des Belichters gefahren. Über den vertikalen Antrieb der Positionierungseinrichtung wird der Zylinder mit der Druckplatte an der Innenseite der Trommel positioniert und die Druckplatte durch Abstellen des Vakuums in die Trommel eingelegt. Zur Entnahme der bebilderten Druckplatte wird derselbe Ablauf der Bewegungen in umgekehrter Reihenfolge durchgeführt. Mit dem Unterschied, dass die Druckplatte nicht wieder in die Kassette zurückgelegt wird, aus der sie entnommen wurde, sondern dass diese in oder auf einen Träger gelegt wird, der anstelle einer Kassette angeordnet sein kann. Dieser Träger ist dann mit einer Entwicklungseinrichtung verbunden. Die beschriebene Vorrichtung ist auch in der Lage, Zwischenpapiere, die sich zum Schutz der zu bebildernden Seite zwischen den einzelnen Druckplatten befinden, mittels desselben, oben beschriebenen Mechanismus zu entfernen. Dies kann beispielsweise während der Bebilderung einer Druckplatte erfolgen. Nachteilig an dieser Vorrichtung ist ihre Kompliziertheit. Zum einen ist ein um seine Achse drehbarer Zylinder mit Saugköpfen notwendig. Zum anderen wird eine sowohl in vertikaler als auch in horizontaler Richtung verfahrbare Einrichtung zur Positionierung des Zylinders benötigt. Nachteilig ist ausserdem die, Grösse der Vorrichtung.

Die Aufgabe der vorliegenden Erfindung ist daher, eine Vorrichtung zu schaffen, die kostengünstig und trotz eines konstruktiv möglichst geringen Aufwandes eine rationelle Bereitstellung von Druckplatten unterschiedlicher Art und Grösse für verschiedenste Arten von Druckplattenbelichtern ermöglicht. Insbesondere soll diese Vorrichtung ebenfalls für die Beladung und Entladung von Trommelbelichtern geeignet sein. Ausserdem soll die Vorrichtung kostengünstig und platzsparend sein.

Eine weitere Aufgabe der vorliegenden Erfindung ist, ein Drucksystem und ein Verfahren zu schaffen, mit dem Belichter, insbesondere Trommelbelichter, effizient mit Druckplatten beladen und entladen werden können.

Gelöst wird die Aufgabe durch eine Vorrichtung nach Anspruch 1, die dadurch gekennzeichnet ist, dass die Saugerplatte zylindersegmentförmig ausgebildet und das Saugmittel um eine Achse schwenkbar ist, die im Wesentlichen parallel zur Achse des Zylindersegmentes angeordnet ist.

Diese Massnahmen ermöglichen in vorteilhafter Weise eine vereinfachte und damit kostengünstige Herstellung und Verwendung der erfindungsgemässen Vorrichtung. Ausserdem ermöglichen diese Massnahmen eine platzsparende Ausbildung der Vorrichtung.

Eine stark vereinfachte Aufnahmevorrichtung ist aufgrund des erfindungsgemässen Saugmittels möglich, wobei das Saugmittel eine Saugerplatte und Saugköpfe umfasst. In diesem Zusammenhang ist unter Platte nicht eine ebene, planare Fläche zu verstehen, sondern die Platte weist die Form eines Zylindersegmentes auf. Aufgrund dieser Form ist es möglich, eine aufgenommene Druckplatte an einen zylinderförmigen Trommelbelichter abzugeben, ohne dass zusätzlich eine Beschickungseinrichtung angeordnet sein muss. Erfindungsgemäss ist das Saugmittel um eine Achse schwenkbar, die im Wesentlichen parallel zur Achse des Zylindersegmentes angeordnet ist. Das Saugmittel behält beim Schwenken seine axiale Ausrichtung im Wesentlichen bei. Die Saugerplatte ist dabei durch die Schwerkraft axial ausgerichtet.

Eine weiterentwickelte Ausführungsform der Erfindung sieht die Verwendung einer Saugerplatte vor, die in Bezug auf ihre Flächenform verformbar ausgebildet ist. Die Saugerplatte kann dabei über Stege an einer oberen Achse der Vorrichtung befestigt sein, wobei der Winkel oder der Abstand zwischen den Stegen veränderbar ist.

In einer Ausführungsform der Erfindung ist die Saugerplatte mittels Spindel mit Spindelantrieb verformbar und die Stege können als Pneumatikzylinder ausgebildet sein. In einer Weiterbildung der Erfindung können die Seiten der Saugerplatte, die parallel zur Achse des Zylindersegments angeordnet sind, in Bezug auf die Flächenform leichter verformbar sein als die Mitte der Saugerplatte.

Durch die Schwenkbewegung kann die Aufnahmevorrichtung verschiedene Höhen erreichen. Bei einer Vorrichtung mit einem Plattenmagazin kann daher auf einen komplizierten Aufzugmechanismus, der die Kassetten bzw. Druckplatten in eine für die Aufnahmevorrichtung zugängliche Position bringt, verzichtet werden. Dabei können einfache Schubladensysteme eingesetzt werden, in denen die Druckplatten gestapelt werden. Die Aufnahmevorrichtung ist so konstruiert, dass durch die bogenförmige Schwenkbewegung des Saugmittels alle Schubladen eines Plattenmagazins erreichbar sind. Vorzugsweise werden solche Schubladen verwendet, die eine Lagerung der Druckplatten ohne Einfluss von Licht ermöglichen.

In einer vorteilhaften Ausgestaltung der Erfindung ist die Bodenplatte oder eine Einlage am Boden einer Schublade konvex gekrümmt. Ein Druckplattenstapel, der in einer Schublade lagert, weist folglich ebenfalls eine solche Wölbung auf. Dabei ist der Radius der Krümmung ungefähr dem Radius der Saugerplatte angepasst. Durch diese Massnahme ist die Verwendung von einer Vielzahl verschiedener Druckplattenformate ermöglicht.

Eine weitere vorteilhafte Massnahme kann darin bestehen, dass sowohl die Öffnung und Schliessung der Schubladen des Plattenmagazins als auch die Bewegung des Saugmittels vollautomatisch und Software-gesteuert geschehen kann.

In einer Weiterbildung der Erfindung können zwei erfindungsgemässe Aufnahmevorrichtungen einen Trommelbelichter beschicken, wobei die eine Vorrichtung zur Entnahme der Druckplatte aus dem Plattenmagazin und anschliessendem Transfer der Druckplatte in einen Belichter und zum Entfernen eines Zwischenpapiers verwendet werden kann und die andere Vorrichtung kann für die Entnahme der bebilderten Druckplatte aus dem Belichter und deren Überführung zu einer Entwicklungsvorrichtung benutzt werden.

Die erfindungsgemässe Vorrichtung lässt sich prinzipiell unabhängig von der Art des Plattenmagazins, vom Druckplattenformat und vom Typ der Belichtungseinrichtung nutzen. Sie kann für jede der eingangs beschriebenen Druckverfahren angewendet werden.

Weitere vorteilhafte Einzelheiten der Erfindung sind in den abhängigen Ansprüchen dargelegt, von denen einzelne wiederum einen eigenen erfinderischen Beitrag über die hier beschriebene grundsätzliche Erfindung haben.

Die Erfindung wird anhand der in den Figuren schematisch dargestellten Ausführungsbeispiele näher erläutert; es zeigen:
- Fig. 1: eine schematische Darstellung der erfindungsgemässen Vorrichtung,
- Fig. 2: eine schematische Darstellung einer Vorrichtung mit zwei erfindungsgemässen Aufnahmevorrichtungen,
- Fig. 3: eine perspektivische Darstellung einer erfindungsgemässen Aufnahmevorrichtung,
- Fig. 4: einen Querschnitt einer schematisch dargestellten, verformbaren Saugerplatte gemäss der vorliegenden Erfindung,
- Fig. 5: einen Querschnitt einer schematisch dargestellten, weiteren Ausführungsform einer verformbaren Saugerplatte gemäss der vorliegenden Erfindung und
- Fig. 6: eine Draufsicht auf eine verformbare Saugerplatte gemäss der vorliegenden Erfindung.

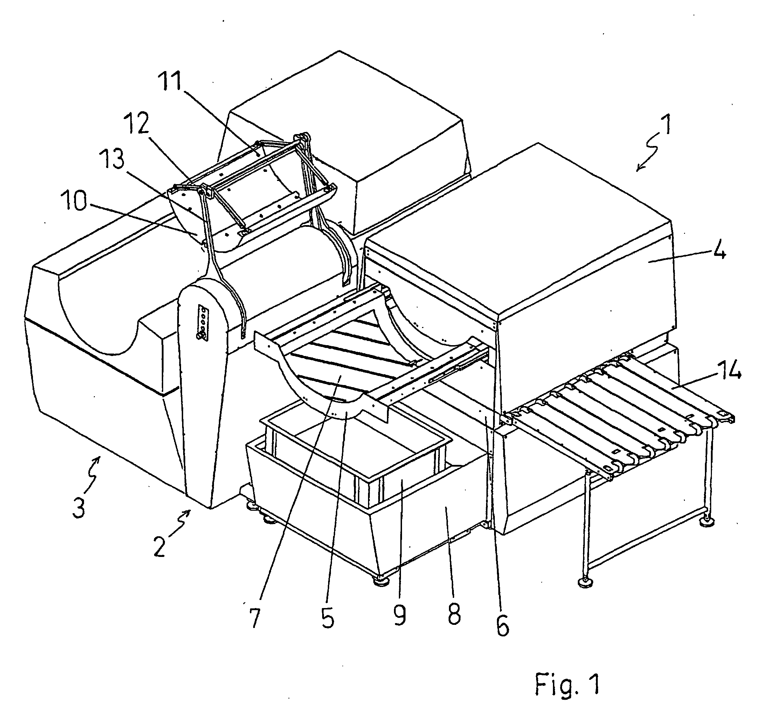

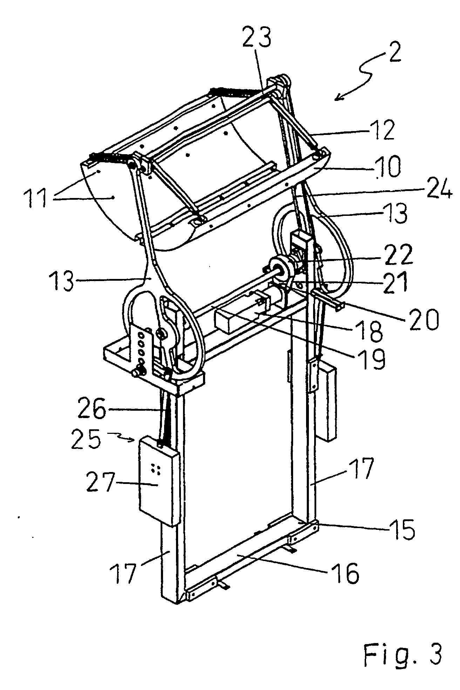

In Fig. 1 ist eine schematische Darstellung der erfindungsgemässen Vorrichtung gezeigt. Die Vorrichtung umfasst ein Plattenmagazin 1, eine Aufnahmevorrichtung 2 und einen Belichter 3. Die erfindungsgemässe Aufnahmevorrichtung 2 ist ohne Verschalung und im Detail in Fig. 3 abgebildet.

Das Plattenmagazin 1 umfasst ein Gehäuse 4 mit mehreren Schubladen 5, 6. Die Bodenplatte einer Schublade 5 ist konvex gekrümmt ausgebildet. Druckplatten 7, hier schraffiert dargestellt, unterschiedlichster Art und von verschiedenen Formaten können stapelartig in eine Schublade 5 gelegt werden. Die Verwendung von Plattenmagazinen, in denen die Druckplatten planar gelagert werden, ist ebenfalls möglich. In der vorliegenden Ausführungsform werden die Schubladen 5 mit Plattenstapel, inklusive der sich als Schutz zwischen den einzelnen Platten befindenden Zwischenpapiere, bestückt. Jeweils ein Plattenformat lagert in einer Schublade 5, wobei die zu bebildernde Seite der Druckplatte 7 nach oben gerichtet ist. Pro Schublade 5 können bis zu 100 Platten gestapelt werden. Dabei passen sich die Druckplatten 7 der Krümmung der Schublade 5 an. Die Schubladen 5 können über einen Elektromotor ausfahrbar angeordnet sein. Eine hier nicht dargestellte Detektierungseinrichtung, wie zum Beispiel ein optischer Sensor, der in oder an einer Schublade angeordnet ist, kann das Fehlen von einer oder mehrerer Druckplatten 7 in einer Schublade 5 erkennen.

An der Frontseite des Plattenmagazins 1 befindet sich eine Wanne 8 mit einem Stapelbehälter 9 zur Aufnahme der vom Plattenstapel entfernten Zwischenpapiere.

Die Aufnahmevorrichtung 2 umfasst eine Saugerplatte 10 mit Saugköpfen 11, die über Stege 12 an Armen 13 angebracht ist. Mittels der Schwenkbewegung der Arme 13 kann eine Druckplatte 7 aus der Schublade 5 entnommen und in einen Trommelbelichter 3 eingelegt werden. Zur Entnahme senkt sich die Saugerplatte 10 auf die Druckplatte 7 ab, bis die Saugköpfe 11 der Saugerplatte 10 mit der Druckplatte 7 Kontakt aufnehmen können. Über Vakuum kann die Druckplatte 7 an der Saugerplatte 10 festgehalten werden. Die Aufnahme eines bestimmten Plattentyps kann dabei durch selektives Anlegen des Vakuums an bestimmte Saugköpfe 11 gesteuert werden.

Der Kontakt der Saugköpfe 11 geschieht mit der zu bebildernden Seite der Druckplatte 7. Das Aufsetzen der Saugköpfe 11 geschieht dabei so, dass ihre seitliche Bewegung auf der Druckplattenoberfläche möglichst gering gehalten wird. Die Saugköpfe 11 sind deshalb so ausgebildet, dass eine Verletzung oder Zerstörung dieser Seite nicht möglich ist. Beispielsweise sind die Saugköpfe 11 aus elastischem, weichen Kunststoffmaterial gefertigt.

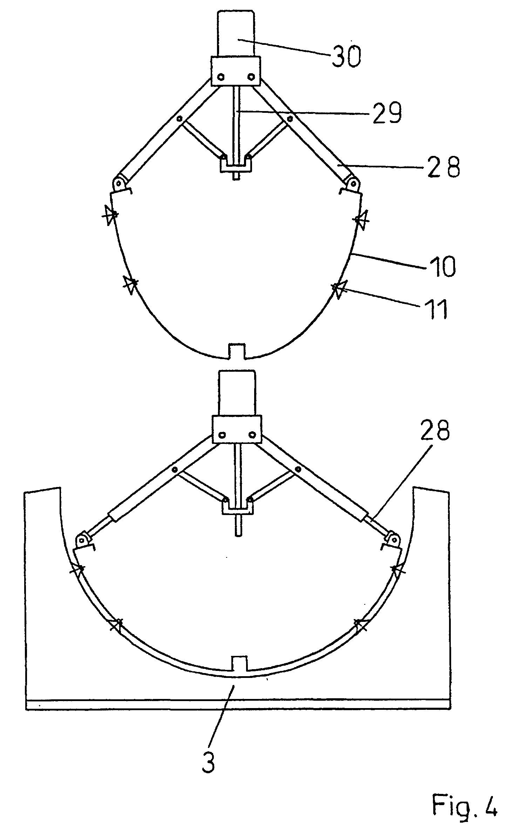

Wie in Fig. 4 dargestellt, kann in einer Ausführungsform der Vorrichtung die Flächenform der Saugerplatte 10 verändert werden. Die Formänderung der Saugerplatte 10 bewirkt, dass Saugköpfe 11, die näher an den Seiten der Saugerplatte 10 angeordnet sind, Kontakt mit der Druckplatte 7 aufnehmen können.

Eine aufgenommene Druckplatte 7 wird mittels einer Schwenkbewegung der Arme 13 in den halbkreisförmigen Trommelbelichter 3 eingesetzt. Je nach Ausführungsform der Vorrichtung, kann die Form der Saugerplatte 10 mit der daran befestigten Druckplatte 7 der Grösse der Öffnung des Belichters 3 angepasst werden. Die genaue Positionierung der Druckplatte 7 im Belichter 3, hier nicht dargestellt, kann entweder über eine Stanzung der Druckplatte 7, die passgenau in, am Belichter 3 angeordnete, Stifte einlegbar ist, erfolgen oder die Position der Druckplatte 7 ist digital erfassbar.

Während der Laser des Belichters 3 die Druckplatte 7 bebildert, kann die Aufnahmevorrichtung 2 ein Zwischenpapier, das sich zum Schutz aufgestapelter Druckplatten 7 zwischen den einzelnen Platten 7 befindet, entfernen. Nach Entnahme einer Druckplatte 7 von einem Plattenstapel, liegt ein solches Zwischenpapier zuoberst in einer Schublade 5. Die Entfernung dieses Blattes geschieht mit dem gleichen Mechanismus wie die Aufnahme einer Druckplatte 7, d.h. über die Saugerplatte 10 und das anlegbare Vakuumsystem. Damit nicht ein Zwischenpapier zusammen mit einer Drückplatte aufgenommen wird, sind verschieden grosse Saugköpfe 11 an der Saugerplatte 10 angeordnet. Ein Zwischenpapier wird dabei mittels Vakuumsystem, das an kleinere Saugköpfe angelegt ist, aufgenommen. Ist das Zwischenpapier aufgenommen, so fährt die Schublade 5 zurück in das Plattenmagazin 1. Durch Beendigung des Vakuums fällt das Blatt in den Stapelbehälter 9 vor dem Plattenmagazin 1.

Über einen hier nicht dargestellten Sensormechanismus, der an der Saugerplatte 10 angeordnet sein kann, ist die Anoder Abwesenheit einer Druckplatte 7 oder eines Zwischenpapiers feststellbar. Beispielsweise kann ein induktiver Detektor melden, ob Metall oder Nichtmetall an der Saugerplatte 10 anliegt.

Nach Bebilderung der Druckplatte 7 und Entfernung des Zwischenpapiers wird die Druckplatte 7 auf die Förderbänder der planaren Schublade 6 mittels der Aufnahmevorrichtung 2 transferiert. Über die Förderbänder, hier nicht dargestellt, der Schublade 6 wird die Platte an die Ausgaberampe 14 abgegeben und kann anschliessend einer, hier nicht dargestellten, Entwicklungseinrichtung zugeführt werden. Die Ausgaberampe 14 kann auch an der Rückseite des Plattenmagazins angeordnet sein.

Sowohl der Aufbau des Belichters 3 als auch der der Entwicklungseinrichtung sind an sich bekannt und bedürfen daher im vorliegenden Zusammenhang keiner näheren Erläuterung.

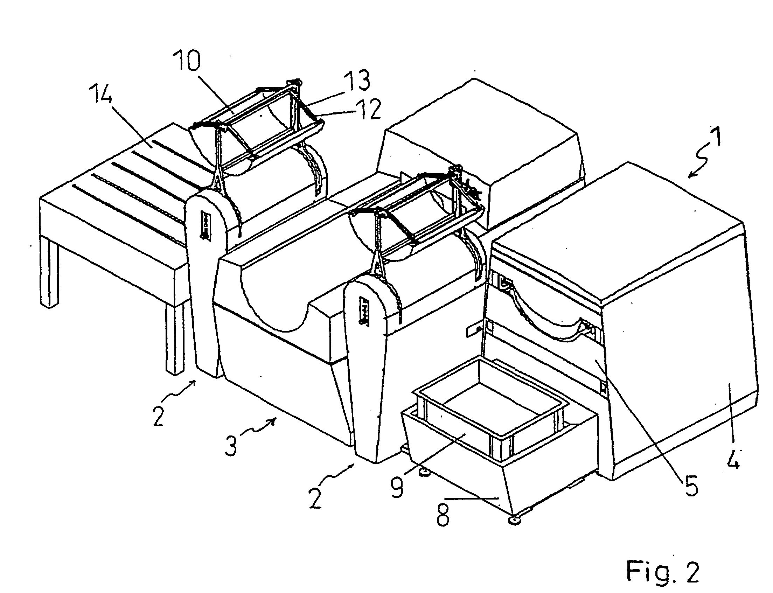

Zur weiteren zeitlichen Optimierung der Druckplattenherstellung können zwei der erfindungsgemässen Aufnahmevorrichtungen 2 an einem Belichter 3 angeordnet sein. Eine schematische Darstellung einer solchen Vorrichtung ist in Fig. 2 gezeigt. Die eine Aufnahmevorrichtung 2 bestückt dabei den Trommelbelichter 3 mit Druckplatten 7 und entfernt die Zwischenpapiere. Diese Aufnahmevorrichtung ist daher einem Plattenmagazin 1 angeordnet. Die andere Aufnahmeeinrichtung 2 entnimmt die bebilderten Druckplatten 7 aus dem Trommelbelichter 3 und gibt diese über eine Ausgaberampe 14 an einen Entwickler, hier nicht dargestellt, weiter.

In Fig. 3 ist die Aufnahmevorrichtung 2 schematisch dargestellt. Diese umfasst ein Gestell 15 mit einem Fussteil 16 und zwei Seitenteilen 17. Die Seitenteile 17 sind an ihrem oberen Ende mit einer drehbaren, über einen Motor 18 angetriebenen unteren Achse oder Welle 19 verbunden. Die Antriebsachse des Motors 18 geht auf ein Ritzel 20. Das Ritzel 20 ist über einen ersten Zahnriemen 21 mit einem Riemenrad 22 wirkverbunden. Das Riemenrad 22 sitzt drehfest auf der Welle 19. Diese ist an beiden Enden mit jeweils einem Arm 13 verbunden. Dabei ist das an der Welle 19 angeordnete Ende der Arme 13 bogen- oder scheibenförmig ausgebildet. Die Arme 13 sind über die Welle 19 synchronisiert und führen parallele Schwenkbewegungen aus. Am anderen Ende der Arme 13 ist über eine Halterung umfassend eine obere Achse 23 und Stege 12, eine Saugerplatte 10 drehbar angeordnet. Die Saugerplatte 10 ist zylindersegmentförmig ausgebildet. Die obere Achse 23 der Saugerplatte 10 ist dabei im Wesentlichen parallel zur Welle 19 angeordnet. Die Saugerplatte 10 ist dabei schwenkbar um die obere Achse 23 angeordnet. Die Saugerplatte 10 behält beim Schwenken die axiale Ausrichtung bei, wobei die Saugerplatte 10 aufgrund der Schwerkraft ausgerichtet wird. Die obere Achse 23 ist über einen zweiten Zahnriemen 24 mit der Welle 19 wirkverbunden. Durch den Antrieb führt die Saugerplatte 10 eine steuerbare Schwenkbewegung aus.

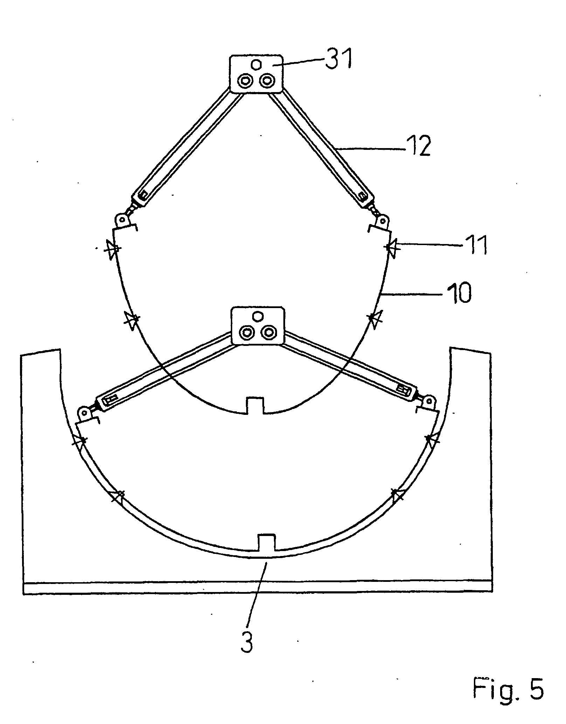

Die Saugerplatte 10 umfasst mindestens zwei Saugköpfe 11. Hier dargestellt sind mehrere Saugköpfe 11, die in Reihen, parallel zur oberen Achse 23 in oder an der Saugerplatte 10 angebracht sind. Es können verschieden grosse Saugköpfe 11 an der Saugerplatte 10 angeordnet sein. Eine andere Anordnung der Saugköpfe 11 ist ebenfalls möglich. Die Saugköpfe 11 sind mit einem hier nicht dargestellten, steuerbaren Vakuumsystem verbunden. Die Saugerplatte 10 ist in Bezug auf ihre Flächenform verformbar ausgebildet. Verschiedene Ausführungsformen der Saugerplatte 10 sind in den Fig. 4 und 5 dargestellt.

Der Antriebsmotor 18 ist durch ein Gegengewichtssytem 25 unterstützt. Dazu ist jeweils am bogenförmigen Ende der Arme 13 eine Stange 26 mit einem Gewicht 27 befestigt. Das Gewicht 27 ist dabei am Gestell 15 geführt, so dass es nur vertikale Bewegungen ausführen kann. Dazu ist je ein Führungswagen am Gewicht 27 und eine Führungsschiene am Gestell 15 angeordnet, beides ist hier nicht dargestellt. Beim Absenken der Arme 13 wird das Gewicht 27 durch die Schwenkbewegung nach oben gezogen, beim Anheben der Arme 13 nach unten. Das um die Achsen 19 wirkende Drehmoment verlangsamt somit beim Absenken die Schwenkbewegung, während es beim Anheben das Drehmoment der Motorkraft unterstützt.

In den Fig. 4 und 5 sind schematisch dargestellt die Querschnitte verschiedener Ausführungsformen einer verformbaren Saugerplatte 10 mit Mittel zur Befestigung an der oberen Achse 23. Das Mittel zur Befestigung in Fig. 4 umfasst zwei Pneumatikzylinder 28 und eine Spindel 29 mit Spindelantrieb 30. In Fig. 5 gezeigt ist ein Mittel zur Befestigung der Saugerplatte 10, das je zwei Stege 12 und ein Verbindungsstück 31, an dem die Stege 12, die obere Achse 23 und die Arme 13, letztere nicht dargestellt, umfasst.

Die Stege 12 bzw. die Pneumatikzylinder 28 sind drehbar an der Saugerplatte 10 und am Verbindungsstück 31 bzw. am Spindelantrieb 30 angebracht. Durch Verkleinerung des Winkels zwischen den Stegen 12 bzw. den Pneumatikzylindern 28 kann die Saugerplatte 10 in Bezug auf ihre Flächenform verformt werden.

Dabei kann die Winkeländerung und damit die Formänderung der Saugerplatte 10 wie in Fig. 4 gezeigt über einen Spindelantrieb 30 gesteuert werden. Alternativ dazu kann die Winkeländerung aufgrund der Schwerkraft induziert werden. Wird die Saugerplatte wie in Fig. 5 dargestellt, vom Trommelbelichter 3 oder von einer Schublade 5 nach oben geführt, so verändert sich der Winkel zwischen den Stegen 12 aufgrund der Schwerkraft, die auf die Saugerplatte 10 wirkt.

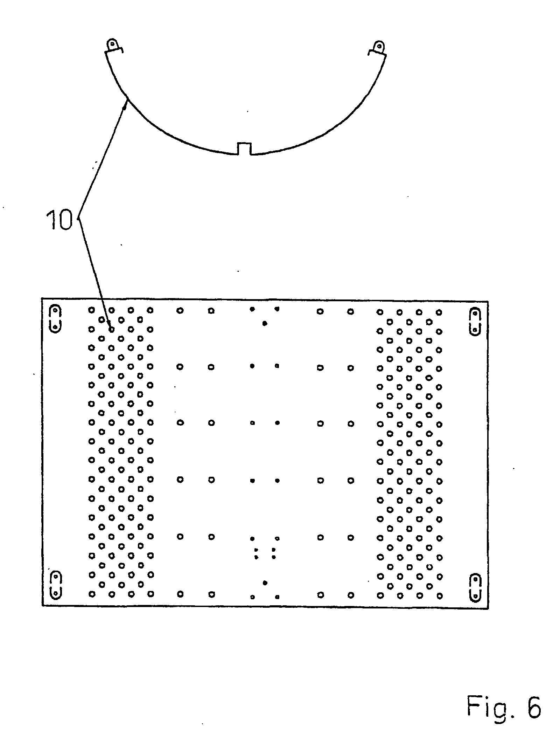

Ein weiteres Ausführungsbeispiel einer Saugerplatte 10 ist in Fig. 6 gezeigt. Die Saugerplatte 10 weist an den Seiten, die parallel zur Achse des Zylindersegmentes angeordnet sind, Löcher auf, so dass sie an diesen Seiten in Bezug auf ihre Flächenform leichter verformbar ist als in der Mitte.

Die Erfindung betrifft auch ein Drucksystem und ein Verfahren zur automatischen Druckplattenbeladung und -entladung. In Fig. 1 ist eine Vorrichtung dargestellt, mit der sich das erfindungsgemässe Verfahren durchführen lässt. Eine Schublade 5 des Plattenmagazins 1, beinhaltend einen Stapel Druckplatten 7 eines bestimmten Formats, wird über einen Antrieb horizontal ausgefahren. Anschiessend wird die Aufnahmevorrichtung 2 in Richtung des Plattenmagazins 1 soweit geschwenkt, dass die Saugerplatte 10 mit der Druckplatte 7 Kontakt aufnehmen kann. In einer Ausführungsform der Erfindung mit verformbarer Saugerplatte 10 nehmen alle Saugköpfe 11 durch das Fortführen der Schwenkbewegung Kontakt mit der Druckplatte 7 auf. Durch Anlegen von Vakuum an die Saugköpfe 11, wird die Druckplatte 7 an der Saugerplatte 10 gehalten. Nach Aufnahme einer Druckplatte 7 an die Saugerplatte 10 wird diese mittels der Schwenkbewegung der Arme 13 in die Trommel des Belichters 3 positioniert und durch Abstellen des Vakuums in die Trommel eingelegt.

Während der Belichter 3 die Druckplatte 7 bebildert, erfolgt die Entnahme des Zwischenpapiers. Dazu schwenken die Arme 13 vom Belichter 3 zurück zu der noch offenen Schublade 5 des Plattenmagazins 1. Die Saugerplatte 10 senkt sich anschliessend auf das Zwischenpapier ab, das sich nach der Wegnahme der Druckplatte 7 zuoberst in der Schublade 5 befindet. Die Aufnahme des Blattes erfolgt über denselben Mechanismus wie die einer Druckplatte 7. Um die Aufnahme einer Druckplatte zusammen mit der eines Zwischenpapiers zu verhindern, wird selektiv das Vakuumsystem an die kleineren Saugköpfe 11 angelegt. Zusätzlich kann über ein Sensormechanismus das Vorhandensein einer Druckplatte 7 und bzw. oder eines Zwischenpapiers an der Saugerplatte 10 detektiert werden.

Nach Aufnahme des Zwischenpapiers durch die Saugerplatte 10 wird die Schublade 5 wieder zurück in das Plattenmagazin 1 gefahren. Durch Abstellen des Vakuums fällt das Zwischenpapier nach unten, in den Stapelbehälter 9 der Wanne 8.

Anschliessend schwenkt die Aufnahmevorrichtung 2 wieder zurück zum Trommelbelichter 3 und nimmt durch Anlegen des Vaküums die bebilderte Druckplatte 7 auf. Die Arme 13 schwenken wieder zurück zur geöffneten Schublade 6. Die Schublade 6 wird geschlossen und die bebilderte Druckplatte 7 wird über die Förderbänder der Schublade 6 an die Ausgaberampe 14 übergeben. Abschliessend wird die Druckplatte 7 mittels der Ausgaberampe 14 der nachgeschalteten Entwicklungseinrichtung zugeführt.

In einer weiteren Ausführungsform des erfindungsgemässen Verfahrens können zwei Aufnahmevorrichtungen 2 zur Be- und Entladung eines Belichters 3 und zur Entfernung eines Zwischenpapiers eingesetzt werden. Die erste Aufnahmevorrichtung 2 entnimmt die Druckplatte 7, beschickt den Belichter 3 und entfernt das Zwischenpapier. Alle Verfahrensschritte werden wie oben beschrieben durchgeführt. Nach erfolgter Bebilderung entnimmt die zweite Aufnahmevorrichtung 2 die bebilderte Druckplatte 7 und übergibt sie entweder direkt an eine Entwicklungseinrichtung oder an eine zwischengeschaltete Ausgaberampe 14. Während die zweite Aufnahmevorrichtung 2 die Druckplatte 7 entnimmt, kann die erste Aufnahmevorrichtung 2 bereits eine nächste Druckplatte 7 aufnehmen und zur Beladung des Belichters 3 bereithalten.

### Bezugszeichenliste

- 1: Plattenmagazin
- 2: Aufnahmevorrichtung
- 3: Belichter, Trommelbelichter
- 4: Gehäuse
- 5: Schublade
- 6: Schublade mit Förderband
- 7: Druckplatte
- 8: Wanne
- 9: Stapelbehälter
- 10: Saugerplatte
- 11: Saugkopf
- 12: Steg
- 13: Arm
- 14: Ausgaberampe
- 15: Gestell
- 16: Fussteil
- 17: Seitenteil
- 18: Motor
- 19: Welle
- 20: Ritzel
- 21: Erster Zahnriemen
- 22: Riemenrad
- 23: Obere Achse
- 24: Zweiter Zahnriemen
- 25: Gegengewichtssystem
- 26: Stange
- 27: Gewicht
- 28: Pneumatikzylinder
- 29: Spindel
- 30: Spindelantrieb
- 31: Verbindungsstück

## Patentansprüche

1. Vorrichtung zur Beladung und/oder Entladung eines Belichters (3), insbesondere eines Trommelbelichters (3), mit Druckplatten (3), mit
- einem, zumindest eine zylindersegmentförmig ausgebildete Saugerplatte (10) und zumindest zwei, an einem Vakuumsystem angeschlossene, Saugköpfe (11) umfassenden Saugmittel (10, 11) zum Aufnehmen von Druckplatten (7), insbesondere von Thermodruckplatten,
- einer Schwenkeinrichtung zum Schwenken des Saugmittels (10, 11),
**dadurch gekennzeichnet, dass**
- das Saugmittel (10, 11) an Armen (13) angebracht ist, die um eine Achse schwenkbar sind, die im Wesentlichen parallel zur Achse des Zylindersegmentes angeordnet ist.

2. Vorrichtung nach Anspruch 1, **dadurch gekennzeichnet, dass** das Saugmittel (10, 11) beim Schwenken die axiale Ausrichtung im Wesentlichen beibehält.

3. Vorrichtung nach Anspruch 1 oder 2, **dadurch gekennzeichnet, dass** die Schwenkeinrichtung zumindest einen Arm (13) umfasst, der an einer Welle (19) drehbar angeordnet ist und dass das Saugmittel um eine zu der Welle (19) im Wesentlichen parallelen Achse (23) schwenkbar ist.

4. Vorrichtung nach Anspruch 3, **dadurch gekennzeichnet, dass** die Schwenkeinrichtung zwei Arme (13) zur Ausführung paralleler Schwenkbewegungen umfasst.

5. Vorrichtung nach einem der Ansprüche 1 bis 4, **dadurch gekennzeichnet, dass** die Schwenkeinrichtung eine Schwenkbewegung von 45° bis 270°, vorzugsweise von 75° bis 240°, ausführen kann.

6. Vorrichtung nach einem der Ansprüche 1 bis 5, **dadurch gekennzeichnet, dass** Saugköpfe (11) unterschiedlicher Grösse in oder an der Saugerplatte (10) angeordnet sind.

7. Vorrichtung nach einem der Ansprüche 1 bis 6, **dadurch gekennzeichnet, dass** die Saugerplatte (10) durch die Schwerkraft axial ausgerichtet wird.

8. Vorrichtung nach einem der Ansprüche 1 bis 7, **dadurch gekennzeichnet, dass** die Saugerplatte (10) zumindest in Bezug auf ihre Flächenform verformbar ausgebildet ist.

9. Vorrichtung nach Anspruch 8, **dadurch gekennzeichnet, dass** die Saugerplatte (10) an den Seiten, die im Wesentlichen parallel zur Achse des Zylindersegments angeordnet sind, in Bezug auf die Flächenform leichter verformbar ist als in der Mitte.

10. Vorrichtung nach einem der Ansprüche 1 bis 9, **dadurch gekennzeichnet, dass** die Saugerplatte (10) an einem Aufhängungsmittel befestigt ist.

11. Vorrichtung nach Anspruch 10, **dadurch gekennzeichnet, dass** das Aufhängungsmittel eine obere Achse (23) der Vorrichtung umfasst, die Saugerplatte (10) über Stege (12) an der oberen Achse befestigt ist und dass der Winkel oder der Abstand zwischen zwei Stegen (12) veränderbar ist.

12. Vorrichtung nach Anspruch 11, **dadurch gekennzeichnet, dass** das Aufhängungsmittel eine Spindel (29) mit einem Spindelantrieb (30) zum Verformen der Saugerplatte (10) umfasst.

13. Vorrichtung nach Anspruch 11 oder 12, **dadurch gekennzeichnet, dass** zumindest einer der Stege (12) einen Pneumatikzylinder (28) umfasst.

14. Vorrichtung nach einem der Ansprüche 1 bis 13, **dadurch gekennzeichnet, dass** das Saugmittel (10, 11) auch zum Entfernen eines Zwischenpapiers ausgebildet ist.

15. Vorrichtung nach einem der Ansprüche 1 bis 14, **gekennzeichnet durch** ein Antriebsmittel, vorzugsweise **durch** einen von einem Gegengewicht (25) unterstützten Motor (18).

16. Vorrichtung nach einem der Ansprüche 1 bis 15, **dadurch gekennzeichnet, dass** sie weiterhin ein Plattenmagazin (1) umfasst.

17. Vorrichtung nach Anspruch 16, **dadurch gekennzeichnet, dass** das Plattenmagazin (1) ausfahrbare Schubladen (5, 6) umfasst, insbesondere Schubladen (5) mit einer konvex gekrümmten Bodenplatte oder konvex gekrümmten Einlage am Boden einer Schublade (5).

18. Vorrichtung nach Anspruch 16 oder 17, **dadurch gekennzeichnet, dass** Druckplatten (7) von unterschiedlichem Format in den Schubladen (5) gestapelt sein können.

19. Vorrichtung nach einem der Ansprüche 16 bis 18, durch **gekennzeichnet, dass** die Schubladen (5) in geschlossenem Zustand lichtundurchlässig sind.

20. Vorrichtung nach einem der Ansprüche 16 bis 19, **dadurch gekennzeichnet, dass** eine Schublade (6) mindestens ein Fördermittel zum Bewegen einer Druckplatte (7), insbesondere ein Förderband, aufweist.

21. Vorrichtung nach einem der Ansprüche 16 bis 20, **dadurch gekennzeichnet, dass** die Schubladen (5, 6) durch einen Antrieb in horizontaler Ebene ausfahrbar sind.

22. Vorrichtung nach einem der Ansprüche 16 bis 21, **gekennzeichnet durch** ein Detektierungsmittel zum Erkennen des Fehlens von mindestens einer Druckplatte (7) in einer Schublade, wobei das Detektierungsmittel in oder an einer Schublade (5) angeordnet ist.

23. Vorrichtung nach Anspruch 22, **dadurch gekennzeichnet, dass** das Detektierungsmittel einen optischen Sensor umfasst.

24. Drucksystem mit einer Vorrichtung nach den Ansprüchen 1 bis 15, wobei eine Druckplatte (7) vom Saugmittel (10, 11) aufgenommen, unter Durchführung einer Schwenkbewegung der Arme (13) in einen Belichter (3), insbesondere einen Trommelbelichter (3), eingelegt und/oder einer Ausgaberampe (14) übergeben werden kann und/oder ein Zwischenpapier entfernt werden kann.

25. Drucksystem mit einer Vorrichtung nach den Ansprüchen 16 bis 23, wobei eine Druckplatte (7) aus einer Schublade (5) vom Saugmittel (10, 11) aufgenommen, unter Durchführung einer Schwenkbewegung der Arme (13) in einen Belichter (3), insbesondere einen Trommelbelichter (3), eingelegt und/oder einerAusgaberampe (14) übergeben werden kann werden kann und/oder ein Zwischenpapier entfernt werden kann.

26. Drucksystem nach Anspruch 24 oder 25, **gekennzeichnet durch** eine erste Vorrichtung gemäss einem der Ansprüche 1 bis 15 zur Beladung eines Belichters (3) und/oder zur Entfernung eines Zwischenpapiers und **durch** eine zweite Vorrichtung nach einem der Ansprüche 1 bis 15 zur Entladung eines Belichters (3).

27. Drucksystem nach den Ansprüchen 24 bis 26, **gekennzeichnet durch** eine Steuerung, wobei mittels der Steuerung das Öffnen der Schubladen (5, 6), der Transfer der Druckplatte (7) vom Plattenmagazin (1) zum Belichter (3), vom Belichter (3) zur Ausgaberampe (14) und/oder die Entfernung eines Zwischenpapieres automatisiert sein kann. '

28. Verfahren zur Beladung und/oder Entladung eines Belichters (3), insbesondere eines Trommelbelichters (3), mit Druckplatten (7) mittels einer Vorrichtung, die ein, zumindest eine Saugerplatte (10) und zumindest zwei, an einem Vakuumsystem angeschlossene, Saugköpfe (11) umfassendes Saugmittel (10, 11) zum Aufnehmen von Druckplatten (7), insbesondere von Thermodruckplatten (7), umfasst, mit einem oder mehreren von den Schritten, dass
- eine Druckplatte (10) vom Saugmittel (10, 11) aufgenommen,
- in einen Belichter (3) eingelegt,
- aus dem Belichter (3) entnommen und
- einer Ausgaberampe (14) übergeben wird und
- ein Zwischenpapier entfernt wird
**dadurch gekennzeichnet, dass**
- die Saugerplatte (10) zylindersegmentförmig ausgebildet ist,
- das Saugmittel (10, 11) an Armen befestigt ist und
- mittels Schwenkbewegung der Arme (13) das saugmittel (10, 11) bewegt wird.

29. Verfahren nach Anspruch 28, **dadurch gekennzeichnet, dass** die Saugerplatte (10) beim Schwenken die axiale Ausrichtung im Wesentlichen beibehält, wobei die Saugerplatte (10) durch die Schwerkraft axial ausgerichtet wird.

30. Verfahren nach einem der Ansprüche 28 oder 29, **dadurch gekennzeichnet, dass** die Saugerplatte (10) durch eine Schwenkeinrichtung um eine Achse im Wesentlichen parallel zur Achse des Zylindersegmentes geschwenkt wird.

31. Verfahren nach einem der Ansprüche 28 bis 30 **dadurch gekennzeichnet, dass** die Saugerplatte (10) zumindest in Bezug auf ihre Flächenform verformt wird.

32. Verfahren nach einem der Ansprüche 28 bis 31, **dadurch gekennzeichnet, dass** die Druckplatten (7) aus einer Schublade eines Plattenmagazins (1) aufgenommen werden.

33. Verfahren nach Anspruch 32, **dadurch gekennzeichnet, dass** die Druckplatte aus ausfahrbaren Schubladen (5, 6), insbesondere Schubladen (5) mit einer konvex gekrümmten Bodenplatte oder einer konvex gekrümmten Einlage an ihrem Boden, aufgenommen werden.

34. Verfahren nach Anspruch 32 oder 33, **dadurch gekennzeichnet, dass** Druckplatten (7) von unterschiedlichem Format in den Schubladen (5) gestapelt sind.

35. Verfahren nach einem der Ansprüche 32 bis 34, **dadurch gekennzeichnet, dass** mit einem Detektierungsmittel zum Erkennen des Fehlens von mindestens einer Druckplatte (7) in einer Schublade (5) das Fehlen von mindestens einer Druckplatte (7) detektiert wird, wobei das Detektierungsmittel in oder an einer Schublade (5) angeordnet ist.

36. Verfahren nach einem der Ansprüche 28 bis 34, **dadurch gekennzeichnet, dass** mittels einer Steuerung sowohl das Öffnen der Schubladen (5, 6), der Transfer der Druckplatte (7) vom Plattenmagazin (1) zum Belichter (3) und/oder vom Belichter (3) zur Ausgaberampe (14) und/oder das Entfernen eines Zwischenpapiers automatisiert abläuft.

37. Verfahren nach einem der Ansprüche 28 bis 36, **dadurch gekennzeichnet, dass** das Beladen des Belichter (3) und/oder das Entfernen eines Zwischenpapiers mittels einer ersten Vorrichtung, die ein, zumindest eine Saugerplatte (10) und zumindest zwei, an einem Vakuumsystem angeschlossene, Saugköpfe (11) umfassendes Saugmittel (10, 11) zum Aufnehmen von Druckplatten (7) umfasst, und das Entladen des Belichters mittels einer zweiten Vorrichtung, die ein, zumindest eine Saugerplatte (10) und zumindest zwei, an einem Vakuumsystem angeschlossene, Saugköpfe (11) umfassendes Saugmittel (10, 11) zum Aufnehmen von Druckplatten (7) umfasst, durchgeführt wird, wobei die Saugerplatte (10) in zumindest einer der genannten Vorrichtungen zylindersegmentförmig ausgebildet ist und das Saugmittel (10, 11) an Armen befestigt ist und mittels Schwenkbewegung der Arme (13) bewegt wird.

38. Verfahren nach Anspruche 37, **dadurch gekennzeichnet, dass** die Saugerplatte (10) zumindest in Bezug auf ihre Flächenform verformt wird.

## Claims

1. A device for loading and/or unloading an imager (3), in particular a drum exposure system (3), with printing plates (3), with
- a suction mechanism (10, 11), comprising at least one suction plate (10) and at least two suction heads (11), connected to a vacuum system, for receiving printing plates (7), in particular thermoprinting plates,
- has a swivelling device for swivelling the suction mechanism (10, 11),
**characterised in that**
- the suction plate (10) is designed as a segment of a cylinder and the suction mechanism (10, 11) can be swivelled about an axis, which is arranged substantially parallel to the axis of the cylinder segment.

2. The device as claimed in Claim 1, **characterised in that** the suction mechanism (10, 11) substantially retains the axial alignment when swivelling.

3. The device as claimed in Claim 1 or 2, **characterised in that** the swivelling device comprises at least one arm (13), which is arranged to pivot on a shaft (19), and **in that** the suction mechanism can swivel about a axis (23) substantially parallel to the shaft (19).

4. The device as claimed in Claim 3, **characterised in that** the swivelling device comprises two arms (13) for executing parallel swivelling movements.

5. The device as claimed in any one of Claims 1 to 4, **characterised in that** the swivelling device can execute a swivelling movement of 45° to 270°, preferably of 75° to 240°.

6. The device as claimed in any one of Claims 1 to 5, **characterised in that** suction heads (11) of different size are arranged in or on the suction plate (10).

7. The device as claimed in any one of Claims 1 to 6, **characterised in that** the suction plate (10) is aligned axially by gravity.

8. The device as claimed in any one of Claims 1 to 7, **characterised in that** the suction plate (10) is designed to deform at least with respect to its surface shape.

9. The device as claimed in Claim 8, **characterised in that** the suction plate (10) is more easily deformed on the sides, which are arranged substantially parallel to the axis of the cylinder segment, than in the middle, with respect to the surface shape.

10. The device as claimed in any one of Claims 1 to 9, **characterised in that** the suction plate (10) is attached to suspension means.

11. The device as claimed in Claim 10, **characterised in that** the suspension means comprise an upper axis (23) of the device, the suction plate (10) is attached by legs (12) on the upper axis, and **in that** the angle or the distance between two legs (12) can be altered.

12. The device as claimed in Claim 11, **characterised in that** the suspension means comprise a spindle (29) with a spindle drive (30) for deforming the suction plate (10).

13. The device as claimed in Claim 11 or 12, **characterised in that** at least one of the legs (12) comprises a pneumatic cylinder (28).

14. The device as claimed in any one of Claims 1 to 13, **characterised in that** the suction mechanism (10, 11) is also designed for removing an intermediate sheet.

15. The device as claimed in any one of Claims 1 to 14, **characterised by** drive means, preferably by an engine (18) supported by a counterweight (25).

16. The device as claimed in any one of Claims 1 to 15, **characterised in that** it also comprises a plate magazine (1).

17. The device as claimed in Claim 16, **characterised in that** the plate magazine (1) comprises retractable drawers (5, 6), in particular drawers (5) with a convex curved base plate or convex curved insert on the floor of a drawer (5).

18. The device as claimed in Claim 16 or 17, **characterised in that** printing plates (7) of differing format can be stacked in the drawers (5).

19. The device as claimed in any one of Claims 16 to 18, **characterised in that** the drawers (5) are impermeable to light when in the closed state.

20. The device as claimed in any one of Claims 16 to 19, **characterised in that** a drawer (6) has at least one conveying means for moving a printing plate (7), in particular a conveying belt.

21. The device as claimed in any one of Claims 16 to 20, **characterised in that** the drawers (5, 6) can be pushed out by a drive in the horizontal plane.

22. The device as claimed in any one of Claims 16 to 21, **characterised by** detection means for recognising the absence of at least one printing plate (7) in a drawer, whereby the detection means are arranged in or on a drawer (5).

23. The device as claimed in Claim 22, **characterised in that** the detection means comprise an optical sensor.

24. A printing system with a device as claimed in Claims 1 to 15, whereby a printing plate (7) is received by the suction mechanism (10, 11), in executing a swivelling movement of the arms (13), laid in an imager (3), in particular a drum exposure system (3), and/or can be transferred to a discharge ramp (14), and/or an intermediate sheet can be removed.

25. A printing system with a device as claimed in Claims 16 to 23, whereby a printing plate (7) is taken out of a drawer (5) by the suction mechanism (10, 11), in executing a swivelling movement of the arms (13) laid in an imager (3), in particular a drum exposure system (3), and/or can be transferred to a discharge ramp (14) and/or an intermediate sheet can be removed.

26. The printing system as claimed in Claims 24 or 25, **characterised by** a first device as claimed in any one of Claims 1 to 15 for loading an imager (3) and/or for removing an intermediate sheet and by a second device as claimed in any one of Claims 1 to 15 for unloading an imager (3).

27. The printing system as claimed in Claims 24 to 26, **characterised by** a control, whereby the opening of the drawers (5, 6), the transfer of the printing plate (7) from the plate magazine (1) to the imager (3), from the imager (3) to the discharge ramp (14) and/or the removing of an intermediate sheet can be automated by means of the control.

28. A method for loading and/or unloading an imager (3), in particular a drum exposure system (3), with printing plates (7) by means of a device, comprising a suction mechanism (10, 11) for receiving printing plates (7), in particular thermoprinting plates (7), having at least one suction plate (10) and at least two suction heads (11), connected to a vacuum system, with one or more of the steps, **characterised in that**
- a printing plate (10) is received by the suction mechanism (10, 11),
- laid in an imager (3),
- removed from the imager (3) and
- is transferred to a discharge ramp (14), and
- an intermediate sheet is removed,
**characterised in that**
- the suction plate (10) is designed as a segment of a cylinder,
- the suction mechanism (10, 11) is attached by arms and
- the suction mechanism (10, 11) is moved by means of swivelling movement of the arms (13).

29. The method as claimed in Claim 28, **characterised in that** the suction plate (10) retains the axial alignment substantially when pivoting, whereby the suction plate (10) is aligned by gravity.

30. The method as claimed in any one of Claims 28 or 29, **characterised in that** the suction plate (10) is pivoted by a swivelling device about an axis substantially parallel to the axis of the cylinder segment.

31. The method as claimed in any one of Claims 28 to 30 **characterised in that** the suction plate (10) is deformed at least with respect to its surface shape.

32. The method as claimed in any one of Claims 28 to 31, **characterised in that** the printing plates (7) are received from a drawer of a plate magazine (1).

33. The method as claimed in Claim 32, **characterised in that** the printing plate is received from retractable drawers (5, 6), in particular drawers (5) with a convex curved base plate or a convex curved insert on their base.

34. The method as claimed in Claim 32 or 33, **characterised in that** printing plates (7) of different format are stacked in the drawers (5).

35. The method as claimed in any one of Claims 32 to 34, **characterised in that** the absence of at least one printing plate (7) is detected by detection means for recognising the absence of at least one printing plate (7) in a drawer (5), whereby the detection means are arranged in or on a drawer (5).

36. The method as claimed in any one of Claims 28 to 34, **characterised in that** both the opening of the drawers (5, 6), the transfer of the printing plate (7) from the plate magazine (1) to the imager (3) and/or from the imager (3) to the discharge ramp (14) and/or the removal of an intermediate sheet is automated by means of a control.

37. The method as claimed in any one of Claims 28 to 36, **characterised in that** loading of the imager (3) and/or removing an intermediate sheet is carried out by means of a first device, which comprises a suction mechanism (10, 11) for receiving printing plates (7), comprising at least one suction plate (10) and at least two suction heads (11), connected to a vacuum system, and unloading the imager by means of a second device, which comprises a suction mechanism (10, 11) for receiving printing plates (7), comprising at least one suction plate (10) and at least two suction heads (11), connected to a vacuum system, whereby the suction plate (10) is designed in at least one of the abovementioned devices as a segment of a cylinder, and the suction mechanism (10, 11) is attached by arms and is moved by means of swivelling movement of the arms (13).

38. The method as claimed in Claim 37, **characterised in that** the suction plate (10) is deformed at least with respect to its surface shape.

## Revendications

1. Dispositif de chargement et/ ou de déchargement d'un traceur, (3), notamment d'un traceur à tambour (3), avec des plaques d'impression (3), avec
- un moyen d'aspiration (10, 11), comprenant au moins une plaque aspirante (10) conçue sous forme de segment cylindrique et au moins deux têtes d'aspiration (11) raccordées sur un système de vide, pour la réception de plaques d'impression (7), notamment de plaques d'impression thermiques,
- un système de pivotement, pour pivoter le moyen d'aspiration (10, 11) ,
**caractérisé en ce que**
- le moyen d'aspiration (11, 11) est monté sur des bras (13) qui sont pivotants autour d'un axe qui est sensiblement disposé à la parallèle de l'axe du segment cylindrique.

2. Dispositif selon la revendication 1, **caractérisé en ce que** lorsqu'il pivote, le moyen d'aspiration (10, 11) garde sensiblement son orientation axiale.

3. Dispositif selon l'une quelconque des revendications 1 ou 2, **caractérisé en ce que** le système de pivotement comprend au moins un bras (13), qui est monté de façon rotative sur un arbre (19) et **en ce que** le moyen d'aspiration est pivotant autour d'un axe (23) sensiblement parallèle à l'arbre (19).

4. Dispositif selon la revendication 3, **caractérisé en ce que** le système de pivotement comprend deux bras (13) pour réaliser des mouvements de pivotement parallèles.

5. Dispositif selon l'une quelconque des revendications 1 à 4, **caractérisé en ce que** le système de pivotement peut réaliser un mouvement de pivotement compris entre 45° et 270 °, de préférence entre 75° et 240°.

6. Dispositif selon l'une quelconque des revendications 1 à 5, **caractérisé en ce que** des têtes d'aspiration (11) de différentes dimensions sont disposées dans ou sur la plaque aspirante (10).

7. Dispositif selon l'une quelconque des revendications 1 à 6, **caractérisé en ce que** la plaque aspirante (10) s'oriente en direction axiale sous l'effet de la gravité.

8. Dispositif selon l'une quelconque des revendications 1 à 7, **caractérisé en ce que** la plaque aspirante (10) est conçue de façon déformable au moins au niveau de sa forme superficielle.

9. Dispositif selon là revendication 8, **caractérisé en ce que**, sur les côtés qui sont sensiblement disposées à la parallèle de l'axe du segment cylindrique, la plaque aspirante (10) est plus facilement déformable au niveau de sa forme superficielle qu'en son centre.

10. Dispositif selon l'une quelconque des revendications 1 à 9, **caractérisé en ce que** la plaque aspirante (10) est fixée sur un moyen d'accrochage.

11. Dispositif selon la revendication 10, **caractérisé en ce que** le moyen d'accrochage comprend un axe supérieur (23) du dispositif, la plaque aspirante (10) est fixée sur l'axe supérieur par l'intermédiaire de barrettes (12) et **en ce que** l'angle ou la distance entre deux barrettes (12) est modifiable.

12. Dispositif selon la revendication 11, **caractérisé en ce que** le moyen d'accrochage comprend une broche (29), avec un entraînement de broche (30) pour.déformer la plaque aspirante (10).

13. Dispositif selon l'une quelconque des revendications 11 ou 12, **caractérisé en ce qu'**au moins l'une des barrettes (12) comprend un cylindre pneumatique (28).

14. Dispositif selon l'une quelconque des revendications 1 à 13, **caractérisé en ce que** le moyen d'aspiration (10, 11) est également conçu pour retirer un papier intermédiaire.

15. Dispositif selon l'une quelconque des revendications 1 à 14, **caractérisé par** un moyen d'entraînement, de préférence par un moteur (18) assisté par un contrepoids (25).

16. Dispositif selon l'une quelconque des revendications 1 à 15, **caractérisé en ce qu'**il comprend par ailleurs un magasin pour plaques (1).

17. Dispositif selon la revendication 16, **caractérisé en ce que** le magasin pour plaques (1) comprend des tiroirs extractibles (5, 6), notamment des tiroirs (5) avec une plaque de fond à courbure convexe ou des inserts à courbure convexe sur le fond d'un tiroir (5).

18. Dispositif selon l'une quelconque des revendications 16 ou 17, **caractérisé en ce que** des plaques d'impression (7) de différents formats peuvent être empilées dans les tiroirs (5).

19. Dispositif selon l'une quelconque des revendications 16 à 18, **caractérisé en ce que** lorsqu'ils sont fermés, les tiroirs (5) sont opaques.

20. Dispositif selon l'une quelconque des revendications 16 à 19, **caractérisé en ce qu'**un tiroir (6) est muni d'au moins un moyen de transport pour déplacer une plaque d'impression (7), notamment d'un tapis de transport.

21. Dispositif selon l'une quelconque des revendications 16 à 20, **caractérisé en ce que** les tiroirs (5, 6) sont extractibles sur un plan horizontal par un entrainement.

22. Dispositif selon l'une quelconque des revendications 16 à 21, **caractérisé par** un moyen de détection, pour l'identification de l'absence d'au moins une plaque d'impression (7) dans un tiroir, le moyen de détection étant disposé dans ou sur un tiroir (5).

23. Dispositif selon la revendication 22, **caractérisé en ce que** le moyen de détection comprend un capteur optique.

24. Système d'impression avec un dispositif selon l'une quelconque des revendications 1 à 15, une plaque d'impression (7) étant saisie par le moyen d'aspiration (10, 11), pouvant être insérée dans un traceur (3), notamment dans un traceur à tambour (3) et/ou transmise à une rampe de sortie (14), sous exécution d'un mouvement pivotant par les bras (13) et/ou un papier intermédiaire pouvant être retiré.

25. Système d'impression avec un dispositif selon l'une quelconque des revendications 16 à 23, une plaque d'impression (7) étant saisie hors d'un tiroir (5) par le moyen d'aspiration (10, 11) pouvant être insérée dans un traceur (13), notamment dans un traceur à tambour (3) et/ou transmise à une rampe de sortie (14), sous exécution d'un mouvement pivotant par les bras (13) et/ou un papier intermédiaire pouvant être retiré.

26. Système d'impression selon l'une quelconque des revendications 24 ou 25, **caractérisé par** un premier dispositif selon l'une quelconque des revendications 1 à 15 pour le chargement d'un traceur (3) et/ou pour le retrait d'un papier intermédiaire et par un second dispositif selon l'une quelconque des revendications 1 à 15, pour le déchargement d'un traceur (3).

27. Système d'impression selon l'une quelconque des revendications 24 à 26, **caractérisé par** un système de commande, l'ouverture des tiroirs (5, 6), le transfert de la plaque d'impression (7) du magasin de plaques (1) vers le traceur (3), du traceur (3) vers la rampe de sortie (14) et/ ou le retrait d'un papier intermédiaire pouvant être automatisés à l'aide du système de commande.

28. Procédé de chargement et/ou de déchargement d'un traceur (3), notamment d'un traceur à tambour (3), avec des plaques d'impression (7), à l'aide d'un dispositif, comprenant un moyen d'aspiration (10, 11) avec au moins une plaque aspirante (10) et au moins deux têtes d'aspiration (11) raccordées à un système de vide pour la préhension de plaques d'impression (7) notamment de plaques d'impression thermiques (7), avec l'une ou plusieurs des étapes au cours desquelles
- une plaque d'impression (10) est saisie par le moyen d'aspiration (10, 11),
- insérée dans un traceur (3),
- retirée hors du traceur (3),
- transmise à une rampe de sortie (14) et
- un papier intermédiaire est retiré
**caractérisé en ce que**
- la plaque aspirante (10) est conçue sous forme d'un segment cylindrique,
- le moyen d'aspiration (10, 11) est fixé à des bras et
- le moyen d'aspiration (10, 11) est déplacé par des mouvements de pivotement des bras (13).

29. Procédé selon la revendication 28, **caractérisé en ce que**, lors du pivotement, la plaque aspirante (10) garde sensiblement son orientation axiale, la plaque aspirante (10) s'orientant en direction axiale par la gravité.

30. Procédé selon l'une quelconque des revendications 28 ou 29, **caractérisé en ce que** la plaque aspirante (10) est pivotée par un dispositif de pivotement autour d'un axe, sensiblement à la parallèle à l'axe du segment cylindrique.

31. Procédé selon l'une quelconque des revendications 28 à 30, **caractérisé en ce que** la plaque aspirante (10) est déformée au moins au niveau de sa forme superficielle.

32. Procédé selon l'une quelconque des revendications 28 à 31, **caractérisé en ce que** les plaques d'impression (7) sont retirées d'un tiroir d'un magasin de plaques (1).

33. Procédé selon la revendication 32, **caractérisé en ce que** les plaques d'impression sont retirées de tiroirs extractibles (5, 6), notamment de tiroirs (5) avec une plaque de fond à courbure convexe ou avec un insert à courbure convexe sur leur fond.

34. Procédé selon l'une quelconque des revendications 32 ou 33, **caractérisé en ce que** des plaques d'impression (7) de différents formats sont empilées dans les tiroirs (5).

35. Procédé selon l'une quelconque des revendications 32 à 34, **caractérisé en ce que** l'absence d'au moins une plaque d'impression (7) est détectée à l'aide d'un moyen de détection pour l'identification de l'absence d'au moins une plaque d'impression (7) dans un tiroir (5), le moyen de détection étant disposé dans ou sur un tiroir (5).

36. Procédé selon l'une quelconque des revendications 28 à 34, **caractérisé en ce que** l'ouverture des tiroirs (5, 6), le transfert de la plaque d'impression (7) du magasin de plaques (1) vers le traceur (3) et/ou du traceur (3) vers la rampe de sortie (14) et ou le retrait d'un papier intermédiaire se déroulent de façon automatisée, par l'intermédiaire d'un système de commande.

37. Procédé selon l'une quelconque des revendications 28 à 36, **caractérisé en ce que** le chargement du traceur (3) et/ou le retrait d'un papier intermédiaire est réalisé à l'aide d'un premier dispositif comprenant un moyen d'aspiration (10, 11) avec au moins une plaque aspirante (10) et au moins deux têtes d'aspiration (11) raccordées à un système de vide pour la préhension de plaques d'impression (7) et le déchargement du traceur est réalisé à l'aide d'un second dispositif comprenant un moyen d'aspiration (10, 11) avec au moins une plaque aspirante (10) et au moins deux têtes d'aspiration (11) raccordées à un système de vide pour la préhension de plaques d'impression (7), la plaque aspirante (10) étant conçue sous forme de segment cylindrique dans au moins l'un des dispositifs cités et le moyen d'aspiration (10, 11) étant fixé sur des bras et déplacé à l'aide de mouvement de pivotement des bras (13).

38. Procédé selon la revendication 37, **caractérisé en ce que** la plaque aspirante (10) est déformée au moins au niveau de sa forme superficielle.
